# FASCICULE DE BREVET EUROPEEN

(11) **EP 3 644 698 B1**
(45) Date de publication et mention de la délivrance du brevet: **15.06.2022**
(21) Numéro de dépôt: 19200886.0
(22) Date de dépôt: 01.10.2019
(51) Int. Cl.: H05K 7/20

(54) **SYSTEME DE GESTION DE TEMPERATURE ET DE GENERATION D'UN FLUX D'AIR DANS UNE ENVELOPPE ELECTRIQUE**
SYSTEM ZUR STEUERUNG DER TEMPERATUR UND DER ERZEUGUNG EINES LUFTSTROMS IN EINER ELEKTRISCHEN HÜLLE
SYSTEM FOR MANAGING TEMPERATURE AND FOR GENERATING AN AIR FLOW IN AN ELECTRIC ENVELOPE

(30) Priorité: 22.10.2018 FR 1859708
(43) Date de publication de la demande: 29.04.2020
(73) Titulaire: Schneider Electric Industries SAS, 92500 Rueil Malmaison (FR)
(72) Inventeur: LOPEZ, Josep, 38050 GRENOBLE (FR); PERRIN, Alain, 38050 GRENOBLE (FR)
(74) Mandataire: Colette, Marie-Françoise

(56) Documents cités:
- EP-A2- 3 349 556
- FR-A1- 2 983 676
- JP-A- 2013 069 890
- JP-A- 2013 239 490
- US-A1- 2007 079 615
- US-A1- 2011 192 173
- US-A1- 2018 160 568

## Description

### Domaine technique de l'invention

La présente invention se rapporte à un système de gestion de température et de génération d'un flux d'air dans une enveloppe électrique. L'invention concerne également une enveloppe électrique intégrant ledit système.

### Etat de la technique

Actuellement, il est difficile de disposer d'une solution unique pour gérer la température à l'intérieur d'une armoire électrique. En effet, la situation peut s'avérer différente selon le type d'appareils électriques ou électroniques qui sont logés dans l'armoire électrique, selon l'environnement dans lequel l'armoire électrique est placée, celle-ci pouvant être placée dans un local dédié, à l'extérieur, dans un environnement chaud, dans un environnement froid ou dans un environnement à température changeante.

Par exemple, lorsque l'armoire électrique est employée en extérieur, il peut s'avérer utile de contrôler la température à l'intérieur de l'armoire, que ce soit pour refroidir les appareils en cas de température ambiante élevée ou même pour réchauffer l'intérieur de l'armoire électrique, en vue d'évacuer l'humidité.

Pour adapter l'armoire aux conditions de son environnement, il est connu de lui adjoindre un système de ventilation comportant un ou plusieurs ventilateurs, un système de refroidissement comportant un climatiseur et/ou un système de chauffage pouvant utiliser une résistance chauffante ou le climatiseur en mode réversible.

Cependant, outre le fait qu'il est nécessaire de connaître les conditions dans lesquelles l'armoire électrique sera placée, certains de ces systèmes sont souvent susceptibles de présenter des défaillances. Dans les armoires électriques, les pannes viennent souvent de l'un de ces systèmes. A titre d'exemple, une interruption prolongée du système de ventilation peut entraîner des risques de surchauffe à l'intérieur de l'armoire électrique et donc des dommages au niveau des appareils électriques ou électroniques qui sont installés dans l'armoire électrique.

JP2013069890 décrit un refroidisseur pour un boîtier comprenant un module à effet Peltier. US2011192173 décrit un dispositif de conditionnement d'air trois canaux pour composants électroniques comprenant un échangeur de chaleur, un module à effet Peltier et des volets commutables. JP2013239490 décrit une structure de boîtier utilisée pour un dispositif électronique, dont un panneau est formé avec une unité de réfrigération dans laquelle un dissipateur de chaleur à rayonnement thermique et un dissipateur de chaleur à absorption thermique sont positionnés respectivement sur les côtés d'un module à effet Peltier. US2018160568 décrit un dispositif d'élimination d'humidité d'une armoire électrique comprenant un module à effet Peltier. US2007079615 décrit un système de refroidissement pour système informatique comprend un boîtier et un module thermoélectrique dans le boîtier. EP3349556 décrit un dispositif électronique comprenant un châssis, une carte de circuit dans le châssis comprenant un premier composant actif, des ventilateurs, des parois de guidage définissant un canal d'entrée d'air, et un refroidisseur thermoélectrique. FR2983676 décrit une armoire électrique à dissipation thermique améliorée.

Le but de l'invention est de proposer une solution permettant de s'affranchir des systèmes classiques décrits ci-dessus, de ventilation, de refroidissement et/ou de chauffage afin de limiter les risques de panne et donc d'éviter les possibles dommages au niveau des appareils électriques ou électroniques logés dans l'armoire électrique.

### Exposé de l'invention

Ce but est atteint par un système de contrôle de température et de génération d'un flux d'air dans une enveloppe électrique, ledit système selon la revendication 1.

Selon une particularité, tous les modules à effet Peltiersont identiques.

Selon une réalisation particulière, la matrice de modules comporte plusieurs modules à effet Peltier, organisés en plusieurs lignes et en au moins une colonne, chaque ligne de modules à effet Peltier étant définie par un rang i avec i allant de 1 à n et n supérieur ou égal à 2 et chaque colonne de modules à effet Peltier étant définie par un rang j avec j allant de 1 à m et m supérieur ou égal à 1.

Selon une autre particularité, l'unité de commande est configurée pour adresser chaque module de la matrice par ses coordonnées i, j dans la matrice.

Selon une autre particularité, les modules à effet Peltier sont agencés sur la matrice de manière à former une surface quasi-continue.

Selon une autre particularité, ladite surface est plane.

Selon une autre réalisation particulière, la goulotte est formée par un tube présentant au moins une paroi délimitant ledit canal, et en ce que ladite paroi du tube forme le support de ladite matrice.

Selon une autre particularité, l'unité de commande comporte un module de détermination d'une température de chaque module à effet Peltier en tenant compte de l'orientation du flux d'air et de l'intensité du flux d'air à générer.

Selon une autre particularité, la goulotte comporte au moins une paroi formée par une paroi de l'enveloppe électrique.

Selon une autre particularité, le système comporte un clapet commandable pour obturer partiellement ou totalement chaque ouverture.

L'invention concerne également une enveloppe électrique comprenant plusieurs parois définissant un volume interne destiné à recevoir des appareils électriques ou électroniques, ladite enveloppe comportant un système de contrôle de température et de génération d'un flux d'air tel que défini ci-dessus.

### Brève description des figures

D'autres caractéristiques et avantages vont apparaître dans la description détaillée qui suit faite en regard des dessins annexés dans lesquels :
- La figure 1 représente de manière schématique, le principe de réalisation du système de l'invention destiné à être appliqué à une armoire électrique ;
- Les figures 2A et 2B représentent en vue de côté, un module à effet Peltier pouvant être employé dans le système de l'invention ;
- Les figures 3A à 3F représentent un premier mode de réalisation du système de l'invention et illustrent son principe de fonctionnement ;
- Les figures 4A et 4B représentent une autre variante de réalisation du système de l'invention, respectivement vue en perspective et vue en coupe transversale ;
- Les figures5A et 5B illustrent deux autres variantes de réalisation du système de l'invention ;

### Description détaillée d'au moins un mode de réalisation

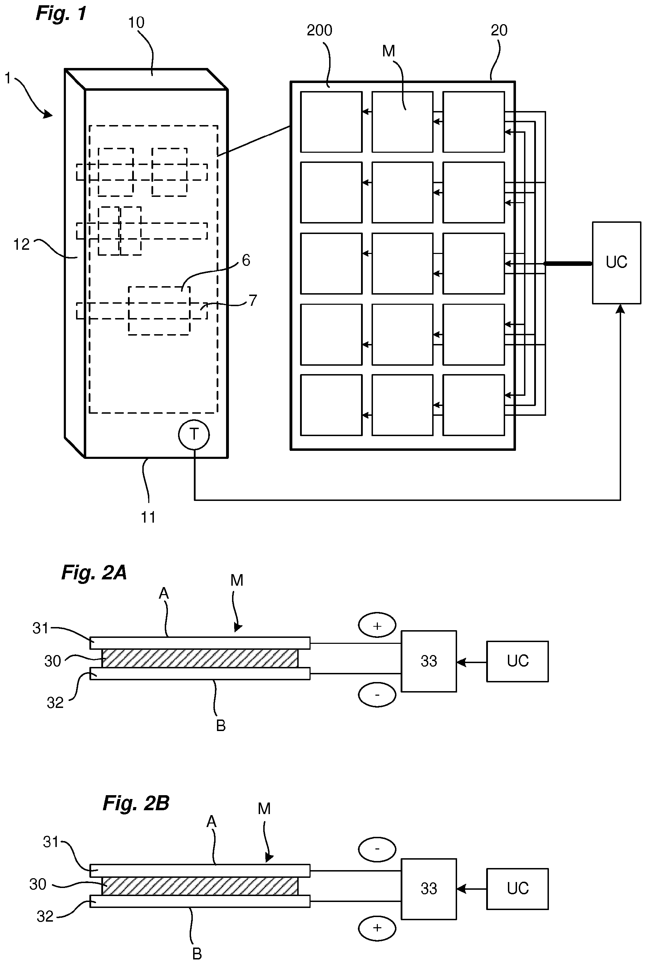

En référence à la figure 1, nous prenons comme application une enveloppe électrique de type armoire électrique 1 présentant une forme parallélépipédique comprenant une paroi supérieure 10, une paroi inférieure 11 et quatre parois latérales 12 opposées deux à deux. Bien entendu, le système de l'invention pourra s'adapter à tous types, toutes formes et tailles d'enveloppes électriques.

L'armoire électrique 1 est destinée à loger des appareils électriques et/ou électroniques 6, par exemple fixés sur des rails 7, et peut comporter une entrée d'air (non représentée) par laquelle est injecté de l'air à l'intérieur de l'armoire électrique 1 et une sortie d'air (non représentée) pour évacuer l'air chaud vers l'extérieur de l'armoire électrique 1. L'invention sera cependant parfaitement adaptée pour une armoire électrique qui est dite étanche, c'est-à-dire sans entrée d'air, ni sortie d'air.

Le système de l'invention peut permettre :
- De créer au moins un flux d'air dans l'armoire électrique 1 suivant une direction donnée ;
- De refroidir ou de chauffer de manière localisée certaines zones à l'intérieur de l'armoire électrique 1 ;

En créant le flux d'air, une circulation d'air peut ainsi être mise en œuvre dans l'armoire électrique, permettant notamment :
- Une homogénéisation de la température dans l'armoire ;
- De faire rentrer de l'air dans l'armoire et/ou d'en rejeter vers l'extérieur ;
- D'éliminer un point chaud ou froid en dirigeant le flux d'air de manière adaptée sur le point chaud ou froid ;

Le système de l'invention comporte une matrice 20 de plusieurs modules à effet Peltier. La matrice 20 peut comporter un support 200 sur lequel sont assemblés et organisés les modules M à effet Peltier.

Les modules M à effet Peltier peuvent être tous identiques.

Dans la matrice, les modules M à effet Peltier peuvent être positionnés de manière adjacente et contigüe pour former une surface quasi-continue. La surface peut être plane ou courbée selon la forme et l'agencement des modules. Idéalement les surfaces de deux modules adjacents de la matrice seront séparées l'une de l'autre par un élément isolant de la chaleur, afin d'éviter un transfert thermique d'un module à l'autre.

En référence aux figures 2A et 2B, chaque module M à effet Peltier présente classiquement une structure interne 30 comprenant des pastilles semi-conductrices fabriquées à partir de matériaux en tellurure de bismuth de type N et de type P. Deux plaques 31, 32 en céramique ayant une conductivité thermique élevée viennent recouvrir la structure de part et d'autre. La série de pastilles est connectée électriquement en série, mais disposée thermiquement en parallèle pour optimiser le transfert thermique entre les surfaces en céramique chaude et froide du module. Sur les modules représentés sur les figures annexées, le gris clair représente une plaque dite froide et le gris foncé représente une plaque dite chaude. L'application d'un courant dans le module M permet d'absorber de la chaleur ou d'en émettre. En appliquant une tension continue à l'aide d'un générateur 33, les porteurs de charges positives et négatives absorbent la chaleur d'une surface de substrat et la transfèrent et la libèrent sur le substrat du côté opposé. Par conséquent, la surface où l'énergie est absorbée devient froide et la surface opposée, où l'énergie est libérée, devient chaude. Il est également possible de modifier la direction du flux de chaleur à l'intérieur du module, simplement en inversant le sens du courant. Ce dernier principe est illustré par les figures 2A et 2B sur lesquelles on peut voir que l'inversion du sens du courant permet d'inverser le sens du flux de chaleur entre les deux plaques 31, 32.

Les deux plaques 31, 32 en céramique peuvent être de format rectangulaire, identiques et superposées de part et d'autre de la structure interne 30 du module, délimitant le contour externe du module. Toute autre forme pourrait être envisagée.

Le système comporte une unité de commande UC destinée à commander chaque module M à effet Peltier de manière indépendante et individualisée.

Chaque module M à effet Peltier peut être commandé directement par l'unité de commande UC en utilisant une liaison point à point (illustrée par chaque flèche sur la figure 1), en lui appliquant un courant électrique et une tension adaptés. Des liaisons électriques permettent de relier chaque module M à l'unité de commande UC. Bien entendu, il faut comprendre que toute autre solution de communication et de commande pourrait être imaginée (bus, liaison sans-fil...).

L'unité de commande UC peut comporter un module de gestion de la température de chaque module en fonction de la puissance électrique à injecter.

Des capteurs de température T peuvent être placés dans l'armoire électrique 1 et à l'extérieur et reliées chacun à l'unité de commande UC pour fournir des données de mesure de température. Les données de mesure de température peuvent être traitées par l'unité de commande UC pour commander chaque module de la matrice de manière adaptée.

Le courant électrique d'alimentation de chaque module M à effet Peltier est caractérisé par son sens et par son intensité. Son sens permet en effet d'orienter le sens du flux de chaleur entre les deux plaques 31, 32 du module M et ainsi définir la face froide et la face chaude du module. L'intensité du courant permet de contrôler le niveau de température de chaque face du module, les températures étant désignés TA et TB pour chaque face A et B du module M.

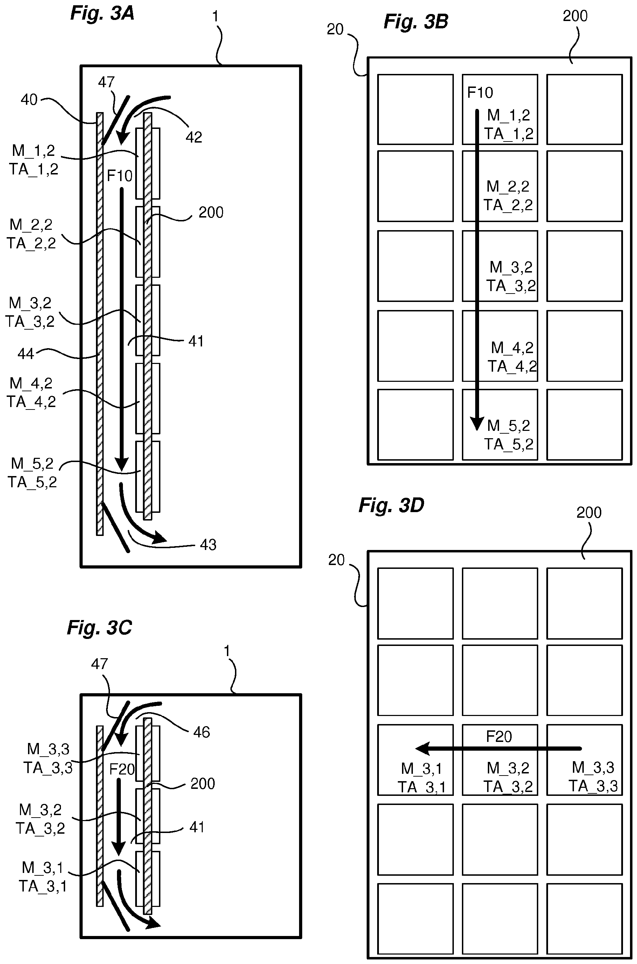

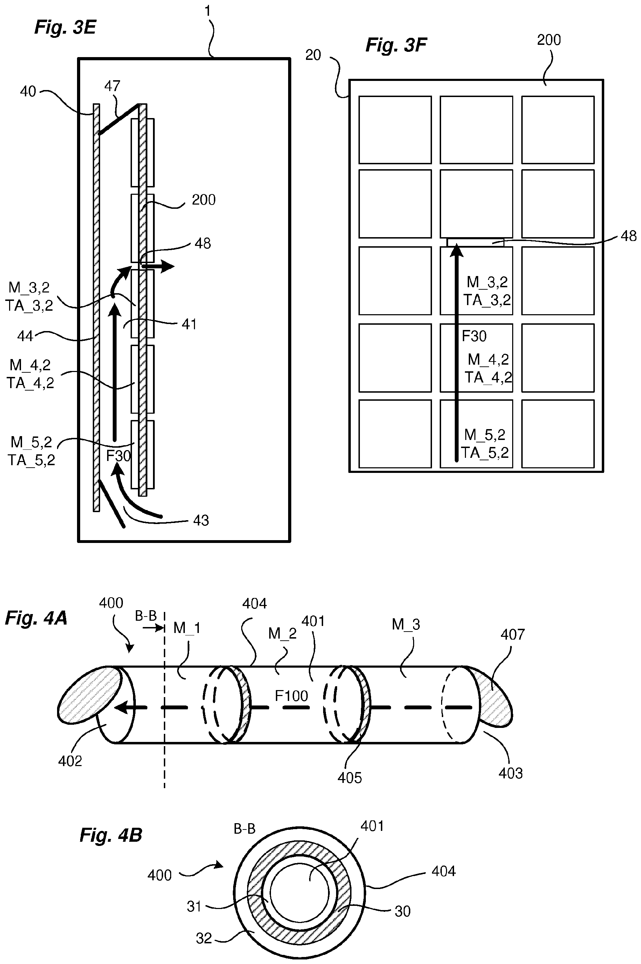

Le système de l'invention comporte une goulotte 40, 400 formant un canal 41, 401 par lequel peut circuler un flux d'air F10, F20, F30, F100 créé grâce au système. La goulotte comporte au moins deux ouvertures 42, 43 ; 402, 403 entre lesquelles est formé ledit canal et est délimitée par au moins une paroi latérale 44, 404 comprenant une face interne située à l'intérieur de la goulotte 40, 400 et une face externe située à l'extérieur de la goulotte. Les deux ouvertures sont par exemple situées à deux extrémités opposées par rapport à la matrice. Il est également possible de prévoir d'autres ouvertures, notamment des ouvertures latérales à travers ladite paroi latérale. Ces ouvertures latérales 46, 48 peuvent être réalisées aux deux extrémités d'un alignement transversal de modules de la matrice, comme on peut le voir sur la figure 3B, ou même à travers le support de la matrice, directement entre deux modules de la matrice, comme on peut le voir sur la figure 3E.

Selon un aspect particulier de l'invention, le support 200 de la matrice 20 peut être positionné de manière à former, au moins partiellement, ladite paroi latérale de la goulotte, au moins un alignement de modules M à effet Peltier de la matrice 20 étant ainsi orienté le long du canal 41, 401. L'une des deux faces de la matrice 20 est ainsi sur la face interne de la paroi de la goulotte l'autre face de la matrice est ainsi sur la face externe de la paroi de la goulotte.

Comme chaque module M à effet Peltier comporte deux faces, destinées chacune à être des températures différentes, on lui attribue deux températures différentes, une première température TA_i,j correspondant à la température de sa face interne destinée à être située à l'intérieur de la goulotte et une deuxième température TB_i,j qui correspond à la température de sa face externe destinée à être située à l'extérieur de la goulotte.

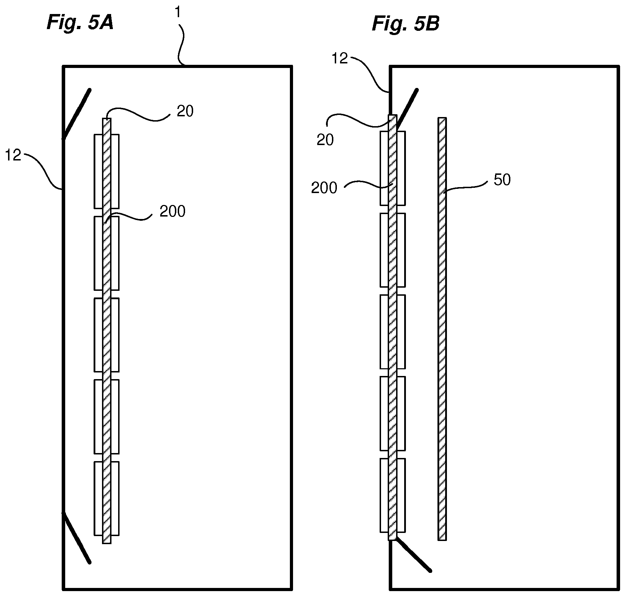

De manière non limitative, ladite goulotte peut être réalisée à l'intérieur de l'armoire électrique 1. Elle peut être réalisée sous la forme d'un ensemble monobloc directement installé dans l'espace de l'armoire électrique 1 (comme représenté sur les figures 3A à 3D) ou utiliser une ou plusieurs parois déjà présentes de l'armoire électrique pour compléter la paroi portant la matrice de modules à effet Peltier. La matrice peut également venir remplacer une paroi 10, 11, 12 de l'armoire électrique, orientant l'une de ses faces à l'extérieur de l'armoire électrique et l'autre à l'intérieur de l'armoire électrique. La goulotte est alors formée par une partie complémentaire située dans l'armoire électrique 1. Les figures 5A et 5B représentent ainsi deux réalisations possibles du système de l'invention. Sur la figure 5A, la goulotte utilise la paroi 12 de l'armoire électrique pour former une partie de sa paroi latérale. Sur la figure 5B, la matrice 20 et son support 200 viennent remplacer une paroi latérale 12 de l'armoire électrique, en ayant une face des modules à l'intérieur de l'armoire électrique et l'autre face des modules à l'extérieur de l'armoire électrique. Une paroi supplémentaire 50 est agencée à l'intérieur de l'armoire électrique pour compléter la paroi latérale de la goulotte.

Selon une particularité, chaque ouverture peut être commandée par un clapet 47, 407 commandable à l'ouverture ou à la fermeture, par l'unité de commande. La position de chaque clapet peut également être contrôlée par l'unité de commande UC de manière à ajuster la vitesse du flux d'air généré.

De manière plus précise, il est ainsi possible de distinguer deux modes de réalisation distincts du système de l'invention.

Dans le premier mode de réalisation représenté sur les figures 3A à 3F, la matrice 20 de modules à effet Peltier se présente sous la forme d'une paroi qui est plane sur ces deux faces, chacune formée par l'alignement quasi-contigu de plusieurs modules à effet Peltier. Cette paroi de modules est agencée pour former l'une des parois de la goulotte, permettant ainsi de générer la face interne de la paroi de la goulotte et la face externe de la paroi de la goulotte. Au moins un flux d'air F10 est généré en suivant un alignement de modules, par le principe de convection naturelle, en allant du module à face interne la plus froide vers le module à face interne la plus chaude. Ce principe est illustré sur les figures 3A et 3B. Un deuxième flux d'air F20 peut également être généré entre un deuxième alignement de modules de la matrice, entre deux ouvertures latérales 46 de la goulotte. Les deux ouvertures 42, 43 peuvent alors être fermées par les clapets 47. Ce principe est illustré sur les figures 3C et 3D. De même, les figures 3E et 3F montrent la création d'un flux d'air F30 entre l'une des ouvertures 42 et une ouverture 48 réalisée directement à travers le support 200 de la matrice de modules. Cette dernière solution sera utile pour venir traiter un point chaud dans l'armoire. Toutes les autres ouvertures peuvent alors être obturées par un clapet commandé. D'autres ouvertures de ce type peuvent être prévues à travers le support 200 de la matrice et même à travers toute la paroi latérale du dispositif pour mieux adapter la direction du flux d'air dans l'armoire électrique.

De manière non limitative, si la matrice 20 est rectangulaire et comporte plusieurs alignements de modules à effet Peltier en lignes et en colonnes, chaque module à effet Peltier peut être identifié par des coordonnées i,j avec i correspondant au numéro de ligne, i allant de 1 à n (n étant supérieur ou égal à 2) et avec j correspondant au numéro de colonne, j allant de 1 à m (m étant supérieur ou égal à 1). Sur les figures 3B et 3D, des modules sont ainsi référencés M_i,j. Bien entendu, lignes et colonnes pourront être inversées selon l'orientation de la matrice.

Il faut noter qu'un module de la matrice qui n'est pas nécessaire à la création du flux d'air demandé peut être déconnecté afin d'éviter de détourner le flux d'air créé. Sur les figures, les modules M déconnectés sont par exemple représentés en blanc.

Dans le deuxième mode de réalisation représentée sur les figures 4A et 4B, la goulotte 400 est formée d'un tube présentant une forme cylindrique (préférentiellement de section circulaire) et définissant un canal 401 ouvert à ses deux extrémités 402, 403. Le tube présente au moins une paroi 404 qui est réalisée par la matrice de modules à effet Peltier. Dans cette réalisation, la paroi 404 portant les modules n'est pas forcément plane et suit ainsi la section du tube. De la même manière que dans le premier mode de réalisation, comme on peut le voir sur la section B-B du tube sur la figure 4B, une face de chaque module est orientée vers l'intérieur du tube et l'autre face de chaque module est orientée vers l'extérieur du tube. Si on se réfère aux figures 2A et 2B, chaque module M est ainsi conformé pour avoir trois couches concentriques formées respectivement, de l'intérieur vers l'extérieur, de la première plaque 31, de la structure 30 et de la deuxième plaque 32. Le tube peut ainsi être réalisé par l'assemblage de plusieurs modules Peltier mis bout à bout d'une extrémité du tube à l'autre. Un organe de support 405 permet d'assurer la liaison d'un module à l'autre et fait office de support de la matrice. Le flux d'air F100 généré traverse le canal 401 formé par le tube, par le principe de convection naturelle, en allant du module à face interne la plus froide vers le module à face interne la plus chaude. De la même manière, des clapets 407 peuvent être prévus pour obturer partiellement ou totalement chaque ouverture du tube. De même, chaque module à effet Peltier du tube pourra être adressé de manière individualisée par l'unité de commande UC. Sur la figure 4A, chaque module est identifié par un rang distinct le long dudit tube et référencé M_k avec k allant de 1 à n. Une ou plusieurs ouvertures intermédiaires peuvent être prévues à travers la paroi latérale 404 du tube, par exemple au niveau de chaque organe de support 405 afin de créer d'autres flux d'air.

Une même armoire électrique 1 peut intégrer plusieurs tubes de ce type, par exemple placés en parallèle ou suivant plusieurs configurations en vue de s'adapter à l'architecture interne de l'armoire. Les tubes peuvent venir s'accrocher sur les supports et rails 7 des appareils électriques 6.

En fonctionnement, la commande individualisée de chaque module à effet Peltier permet d'imaginer différentes applications.

Une première application concerne la création d'un flux d'air dans la goulotte en créant un gradient de température sur la face interne de la goulotte. Le gradient est créé en commandant de manière adaptée les modules de la matrice 20 qui sont présents dans l'alignement du flux d'air à générer en adaptant la température de la face A de la matrice qui correspond à la face interne. Par convection naturelle, un flux d'air est en effet créé dans le sens allant du froid vers le chaud.

Ainsi, en considérant le premier mode de réalisation ci-dessus, un alignement suivant une colonne j comprenant n modules et un flux d'air à générer qui correspond à la croissance du rang i, on a :
- Le module ayant pour coordonnées M_1,j est commandé par l'unité de commande UC pour placer sa face interne à une première température TA_1,j ;
- Le module ayant pour coordonnées M_2,j est commandé par l'unité de commande UC pour placer sa face interne à une deuxième température TA_2,j qui est supérieure à la première température TA_1,j ;
- Le module ayant pour coordonnées M_i,j est commandé par l'unité de commande UC pour placer sa face interne à une température TA_i,j qui est supérieure à la température TA_i-1 ,j ;
- Le module ayant pour coordonnées M_n,j est commandé par l'unité de commande UC pour placer sa face interne à une température TA_n,j qui est supérieure à la température TA_n-1 ,j ;

Ce principe est illustré par les figures 3A et 3B avec la génération d'un flux d'air F10 par un alignement vertical de modules suivant la deuxième colonne de la matrice (j=2). Le même principe peut s'appliquer suivant une ligne de la matrice, comme illustré sur les figures 3C et 3D, en employant les ouvertures latérales de la goulotte. Sur les figures 3C et 3D, le flux F20 est créé par un alignement de modules suivant la troisième ligne de la matrice 20 (i=3). Le principe sera identique pour générer le flux d'air F30 ou même le flux d'air F100 à l'intérieur du tube.

Le principe de fonctionnement peut alors être le suivant :
- L'unité de commande UC reçoit en permanence des données de température en provenance des capteurs de température T ;
- En fonction des données de température reçues, l'unité de commande UC détermine si la génération d'un ou plusieurs flux d'air est nécessaire et, si oui, détermine le sens de chaque flux d'air à générer et leur intensité ;
- Une fois que les caractéristiques de chaque flux d'air à générer sont déterminées, l'unité de commande UC détermine les modules M de la matrice 20 concernées par la création du flux d'air et détermine la température à affecter à chaque module pour créer un gradient de température suffisant pour la génération du flux d'air ;
- L'unité de commande UC envoie une commande en température individualisée à chaque module à effet Peltier pour lui faire prendre la température souhaitée ;
- Par convection naturelle, le flux d'air est généré entre les modules de la matrice sélectionnés. Les ouvertures du système qui sont adaptées au passage du flux d'air à générer sont commandés à l'ouverture pour permettre au flux d'air de circuler ;
- À tout moment, l'unité de commande UC peut interrompre le flux d'air en déconnectant un ou plusieurs des modules à effet Peltier sélectionnés et définir une nouvelle série de commandes pour la création d'un nouveau flux d'air ;

Bien entendu, le gradient de température créé devra être suffisant et adapté au flux d'air à générer. L'unité de commande UC peut comporter un algorithme configuré pour déterminer la température à affecter à chaque module à effet Peltier en tenant compte de la direction et du sens du flux d'air à générer et de son intensité.

Par ailleurs, il faut comprendre que deux modules adjacents de l'alignement peuvent être commandés à une même température.

Une deuxième application est liée à l'obtention d'un refroidissement ou d'un chauffage localisé dans l'armoire électrique. Pour cela, en fonction des données de température reçues, l'unité de commande peut commander un ou plusieurs modules à effet Peltier de la matrice pour abaisser la température (en cas de présence d'un point chaud) ou augmenter la température (par exemple pour évacuer l'humidité présente).

La goulotte peut comporter plus de deux ouvertures de manière à pouvoir générer différents types de flux d'air. Chaque ouverture peut être commandée par un clapet commandable à l'ouverture ou à la fermeture.

Selon un aspect particulier de l'invention, pour agir sur la vitesse du flux d'air chaque clapet peut être commandé pour ajuster la taille de son ouverture respective. Il peut ainsi être possible de créer une accélération du flux d'air en jouant sur la taille des ouvertures.

On comprend que la solution de l'invention présente de nombreux avantages, parmi lesquels :
- Une solution facile à mettre en place ;
- Une solution fiable, peu susceptible de subir des défaillances, au contraire des solutions classiques de ventilation ;
- Une solution qui nécessite un entretien limité, les modules à effet Peltier ne disposant d'aucune pièce mécanique et étant particulièrement facile à remplacer ;
- Une solution permettant de créer des flux d'air dans plusieurs directions, à la commande, sans aucune intervention ;

## Revendications

1. Système de gestion de température et de génération d'un flux d'air dans une enveloppe électrique, comportant:
- Une goulotte (40, 400) comprenant au moins une première ouverture, une deuxième ouverture et un canal (41, 401) agencé entre ladite première ouverture et ladite deuxième ouverture pour faire passer ledit flux d'air entre les deux ouvertures,
- Une matrice (20) de plusieurs modules (M) à effet Peltier indépendants,
- Ladite matrice comprenant au moins un alignement de plusieurs modules à effet Peltier agencé suivant une direction dite principale, chaque module à effet Peltier de la matrice comprenant deux faces opposées et étant adressable de manière individualisée pour créer ledit effet Peltier entre ses deux faces, et en ce que
- Ledit alignement de plusieurs modules (M) à effet Peltier étant orienté le long dudit canal, chaque module de la matrice présentant une face à l'intérieur de la goulotte et une face à l'extérieur de ladite goulotte,
- Une unité de commande (UC) configurée pour commander chaque module à effet Peltier de la matrice de manière individualisée,
- **caractérisé en ce que** l'unité de commande (UC) comporte un module de détermination des modules à effet Peltier à commander en température en fonction de la direction et du sens du flux d'air à générer dans la goulotte.

2. Système selon la revendication 1, **caractérisé en ce que** tous les modules (M) à effet Peltier sont identiques.

3. Système selon la revendication 1 ou 2, **caractérisé en ce que** la matrice (20) de modules comporte plusieurs modules à effet Peltier, organisés en plusieurs lignes et en au moins une colonne, chaque ligne de modules à effet Peltier étant définie par un rang i avec i allant de 1 à n et n supérieur ou égal à 2 et chaque colonne de modules à effet Peltier étant définie par un rang j avec j allant de 1 à m et m supérieur ou égal à 1.

4. Système selon la revendication 3, **caractérisé en ce que** l'unité de commande (UC) est configurée pour adresser chaque module de la matrice par ses coordonnées i, j dans la matrice.

5. Système selon la revendication 4, **caractérisé en ce que** les modules à effet Peltier sont agencés sur la matrice de manière à former une surface quasi-continue.

6. Système selon la revendication 5, **caractérisé en ce que** ladite surface est plane.

7. Système selon la revendication 1 ou 2, **caractérisé en ce que** la goulotte (400) est formée par un tube présentant au moins une paroi délimitant ledit canal, et **en ce que** ladite paroi du tube forme le support de ladite matrice.

8. Système selon l'une des revendications 1 à 7, **caractérisé en ce que** l'unité de commande (UC) comporte un module de détermination d'une température de chaque module à effet Peltier en tenant compte de l'orientation du flux d'air et de l'intensité du flux d'air à générer.

9. Système selon la revendication 1, **caractérisé en ce que** la goulotte (40) comporte au moins une paroi formée par une paroi de l'enveloppe électrique.

10. Système selon l'une des revendications 1 à 9, **caractérisé en ce qu'**il comporte un clapet commandable pour obturer partiellement ou totalement chaque ouverture.

11. Enveloppe électrique comprenant plusieurs parois définissant un volume interne destiné à recevoir des appareils électriques ou électroniques, **caractérisée en ce qu'**elle comporte un système de contrôle de température et de génération d'un flux d'air tel que défini dans l'une des revendications 1 à 10.

## Patentansprüche

1. System zur Verwaltung der Temperatur und Erzeugung eines Luftstroms in einem elektrischen Gehäuse, umfassend:
- eine Rinne (40, 400), umfassend mindestens eine erste Öffnung, eine zweite Öffnung und einen Kanal (41, 401), der zwischen der ersten Öffnung und der zweiten Öffnung angeordnet ist, um den Luftstrom zwischen den beiden Öffnungen durchzulassen,
- eine Matrix (20) aus mehreren unabhängigen Peltier-Effekt-Modulen (M),
- wobei die Matrix mindestens eine Aneinanderreihung aus mehreren Peltier-Effekt-Modulen umfasst, die entlang einer Richtung, Hauptrichtung genannt, angeordnet ist, wobei jedes Peltier-Effekt-Modul der Matrix zwei entgegengesetzte Seiten umfasst und einzeln adressierbar ist, um den Peltier-Effekt zwischen seinen beiden Seiten zu generieren, und dass
- wobei die Aneinanderreihung aus mehreren Peltier-Effekt-Modulen (M) entlang des Kanals ausgerichtet ist, wobei jedes Modul der Matrix eine Seite innerhalb der Rinne und eine Seite außerhalb der Rinne aufweist,
- eine Steuereinheit (UC), die dazu ausgestaltet ist, jedes Peltier-Effekt-Modul der Matrix einzeln zu steuern,
- **dadurch gekennzeichnet, dass** die Steuereinheit (UC) ein Modul zur Bestimmung der temperaturzusteuernden Peltier-Effekt-Module in Abhängigkeit von der Richtung und dem Richtungssinn des in der Rinne zu erzeugenden Luftstroms beinhaltet.

2. System nach Anspruch 1, **dadurch gekennzeichnet, dass** alle Peltier-Effekt-Module (M) identisch sind.

3. System nach Anspruch 1 oder 2, **dadurch gekennzeichnet, dass** die Matrix (20) aus Modulen mehrere Peltier-Effekt-Module beinhaltet, die in mehreren Zeilen und in mindestens einer Spalte organisiert sind, wobei jede Zeile aus Peltier-Effekt-Modulen durch einen Rang i mit i von 1 bis n und n größer oder gleich 2 definiert ist und jede Spalte aus Peltier-Effekt-Modulen durch einen Rang j mit j von 1 bis m und m größer oder gleich 1 definiert ist.

4. System nach Anspruch 3, **dadurch gekennzeichnet, dass** die Steuereinheit (UC) dazu ausgestaltet ist, jedes Modul der Matrix über seine Koordinaten i, j in der Matrix zu adressieren.

5. System nach Anspruch 4, **dadurch gekennzeichnet, dass** die Peltier-Effekt-Module auf der Matrix so angeordnet sind, dass eine nahezu durchgehende Fläche gebildet wird.

6. System nach Anspruch 5, **dadurch gekennzeichnet, dass** die Fläche eben ist.

7. System nach Anspruch 1 oder 2, **dadurch gekennzeichnet, dass** die Rinne (400) durch ein Rohr gebildet wird, das mindestens eine den Kanal begrenzende Wand aufweist, und dass die Wand des Rohrs den Träger der Matrix bildet.

8. System nach einem der Ansprüche 1 bis 7, **dadurch gekennzeichnet, dass** die Steuereinheit (UC) ein Modul zum Bestimmen einer Temperatur jedes Peltier-Effekt-Moduls unter Berücksichtigung der Ausrichtung des Luftstroms und der Intensität des zu erzeugenden Luftstroms beinhaltet.

9. System nach Anspruch 1, **dadurch gekennzeichnet, dass** die Rinne (40) mindestens eine Wand beinhaltet, die durch eine Wand des elektrischen Gehäuses gebildet wird.

10. System nach einem der Ansprüche 1 bis 9, **dadurch gekennzeichnet, dass** es eine steuerbare Klappe zum teilweisen oder vollständigen Verschließen jeder Öffnung beinhaltet.

11. Elektrisches Gehäuse, das mehrere Wände umfasst, die einen Innenraum definieren, der zum Aufnehmen elektrischer oder elektronischer Geräte bestimmt ist, **dadurch gekennzeichnet, dass** es ein System zur Überwachung der Temperatur und Erzeugung eines Luftstroms wie in einem der Ansprüche 1 bis 10 definiert beinhaltet.

## Claims

1. System for managing temperature and for generating an airflow in an electrical housing, comprising:
- a duct (40, 400) comprising at least a first aperture, a second aperture and a channel (41, 401) arranged between said first aperture and said second aperture in order to allow said airflow to pass between the two apertures,
- a matrix array (20) of a plurality of independent thermoelectric modules (M),
- said matrix array comprising at least one line of a plurality of thermoelectric modules arranged in a direction referred to as the main direction, each thermoelectric module of the matrix array having two opposite faces and being addressable individually with a view to generating a thermoelectric effect between its two faces, and in that
- said line of a plurality of thermoelectric modules (M) being oriented along said channel, each module of the matrix array having a face inside the duct and a face outside said duct,
- a control unit (UC) configured to control each thermoelectric module of the matrix array individually,
- **characterized in that** the control unit (UC) comprises a module for determining thermoelectric modules the temperature of which is to be controlled depending on the direction and on the sense of the airflow to be generated in the duct.

2. System according to Claim 1, **characterized in that** all the thermoelectric modules (M) are identical.

3. System according to Claim 1 or 2, **characterized in that** the matrix array (20) of modules comprises a plurality of thermoelectric modules that are organized into a plurality of rows and at least one column, each row of thermoelectric modules being defined by a rank i with i ranging from 1 to n and n being higher than or equal to 2 and each column of thermoelectric modules being defined by a rank j with j ranging from 1 to m and m being higher than or equal to 1.

4. System according to Claim 3, **characterized in that** the control unit (UC) is configured to address each module of the matrix array via its coordinates i, j in the matrix array.

5. System according to Claim 4, **characterized in that** the thermoelectric modules are arranged in the matrix array so as to form an almost continuous surface.

6. System according to Claim 5, **characterized in that** said surface is planar.

7. System according to Claim 1 or 2, **characterized in that** the duct (400) is formed by a tube having at least one wall bounding said channel, and **in that** said wall of the tube holds said matrix array.

8. System according to one of Claims 1 to 7, **characterized in that** the control unit (UC) comprises a module for determining a temperature of each thermoelectric module taking into account the orientation of the airflow and the strength of the airflow to be generated.

9. System according to Claim 1, **characterized in that** the duct (40) comprises at least one wall formed by a wall of the electrical housing.

10. System according to one of Claims 1 to 9, **characterized in that** it comprises a controllable valve for partially or completely blocking each aperture.

11. Electrical housing comprising a plurality of walls defining an internal volume intended to receive electrical or electronic devices, **characterized in that** it comprises a system for controlling temperature and for generating an airflow such as defined in one of Claims 1 to 10.
